(19) Europäisches Patentamt / European Patent Office / Office européen des brevets

(11) **EP 3 026 447 B1**

(12) **FASCICULE DE BREVET EUROPEEN**

(45) Date de publication et mention
de la délivrance du brevet:
**03.01.2018 Bulletin 2018/01**

(51) Int Cl.:
***G01R 21/133*** (2006.01)  ***G01R 29/04*** (2006.01)

(21) Numéro de dépôt: **15195955.8**

(22) Date de dépôt: **24.11.2015**

(54) **PROCÉDÉ ET DISPOSITIF DE DÉTERMINATION D'UNE PUISSANCE ÉLECTRIQUE APPARENTE CONSOMMÉE PAR UNE INSTALLATION ÉLECTRIQUE**

VERFAHREN UND VORRICHTUNG ZUR BESTIMMUNG EINER ELEKTRISCHEN SCHEINLEISTUNG, DIE VON EINER ELEKTRISCHEN ANLAGE VERBRAUCHT WIRD

METHOD AND DEVICE FOR DETERMINING THE APPARENT ELECTRIC POWER CONSUMED BY AN ELECTRIC SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.11.2014 FR 1461430**

(43) Date de publication de la demande:
**01.06.2016 Bulletin 2016/22**

(73) Titulaire: **SAGEMCOM ENERGY & TELECOM SAS**
**92500 Rueil-Malmaison (FR)**

(72) Inventeurs:
 • **TEBOULLE, Henri**
  **92500 Rueil Malmaison (FR)**
 • **NOIRET, Sébastien**
  **92500 Rueil Malmaison (FR)**
 • **GRINCOURT, Christophe**
  **92500 Rueil Malmaison (FR)**

(74) Mandataire: **Le Guen-Maillet**
 **5, place de Newquay**
 **BP 70250**
 **35802 Dinard Cedex (FR)**

(56) Documents cités:
 **WO-A1-01/29572   US-A1- 2006 129 339**

**Description**

La présente invention concerne une détermination par un compteur électrique d'une puissance apparente consommée par une installation électrique supervisée par ledit compteur électrique, et plus particulièrement dans le cadre d'un signal de courant électrique pouvant prendre la forme d'un signal dissymétrique.

Des compteurs électriques permettent de calculer et fournir une information de puissance apparente consommée par des installations électriques respectives supervisées par lesdits compteurs électriques. De tels compteurs électriques disposent notamment d'étages de conversion analogique-numérique et d'étages d'amplification/atténuation à base d'amplificateurs opérationnels. Ceci entraîne que le signal de courant électrique fourni par un réseau d'alimentation électrique est vu par un tel compteur électrique potentiellement avec une composante continue, intrinsèque au compteur électrique, c'est-à-dire que cette composante continue est inexistante dans le signal de courant électrique fourni par le réseau d'alimentation électrique. Il convient de ne pas prendre en compte cette composante continue intrinsèque au compteur électrique dans le calcul de la puissance apparente consommée par l'installation électrique supervisée. Pour ce faire, le compteur électrique détermine une moyenne du signal de courant électrique et retire cette moyenne déterminée lors du calcul de la puissance apparente consommée.

Cette approche fonctionne bien lorsque le signal de courant électrique est symétrique, c'est-à-dire lorsque le signal de courant électrique oscille de manière équirépartie autour de la valeur nulle, ce qui est typiquement le cas d'un signal sinusoïdal centré autour de la valeur nulle. Dans cas, il n'y a en effet pas de composante continue intrinsèque au signal de courant électrique fourni par le réseau d'alimentation électrique.

Cependant, il existe des situations, comme celles définies dans certaines exigences normatives et/ou spécifications de compteurs électriques fournies par des fournisseurs d'énergie (telles que, par exemple, une demi-onde de courant définie dans la norme NF-EN 50470-3:2007), dans lesquelles le signal de courant électrique fourni par le réseau d'alimentation électrique est dissymétrique, c'est-à-dire que le signal de courant électrique n'oscille pas de manière équirépartie autour de la valeur nulle. Cette dissymétrie entraîne une composante continue, qui est alors intrinsèque au signal fourni. En suivant l'approche consistant à déterminer une moyenne du signal de courant électrique et à retirer cette moyenne déterminée lors du calcul de la puissance apparente, le compteur électrique se retrouve à ne pas prendre en compte, dans le calcul de la puissance apparente consommée, la composante continue intrinsèque au signal. Or cette composante continue intrinsèque au signal doit faire partie intégrante du calcul de la puissance apparente, contrairement à la composante continue intrinsèque au compteur électrique.

De plus, il est possible qu'un compteur électrique comprenne un circuit de mesure de courant coupant la composante continue d'un signal (par exemple en présence de transformateurs de courant dans le cas d'un compteur triphasé).Dans ce cas il est nécessaire de déterminer quelle est la valeur du continu avant coupure pour calculer correctement la puissance apparente.

Des compteurs électriques sont connus des documents US 2006/0129339 A1 et WO 01/29572 A1. Il est souhaitable de pallier ces différents inconvénients de l'état de la technique.

Il est notamment souhaitable de fournir une solution qui permette de déterminer la puissance apparente consommée par une installation électrique, lorsque le signal de courant électrique prend la forme d'un signal dissymétrique.

Il est notamment souhaitable de fournir une solution qui soit simple à mettre en oeuvre et à faible coût.

Selon un premier aspect de la présente invention, l'invention concerne un procédé de détermination par un compteur électrique d'une puissance électrique apparente consommée par une installation électrique supervisée par ledit compteur électrique, un signal de courant électrique étant fourni au compteur électrique pour alimenter ladite installation électrique. Le procédé comprend les étapes suivantes mises en oeuvre par le compteur électrique : mesurer une valeur de courant efficace à partir du signal de courant électrique ; obtenir une valeur de décalage de courant ; corriger la valeur de courant efficace en utilisant la valeur de décalage de courant obtenue ; et, calculer une valeur de puissance électrique apparente à partir de la valeur de courant efficace corrigée. Le compteur électrique met en oeuvre les étapes suivantes pour déterminer la valeur de décalage de courant : rechercher dans le signal de courant électrique une période, dite zone plate, pour laquelle un pourcentage d'échantillons du signal de courant électrique, dits échantillons non singuliers, est supérieur ou égal à un seuil, dit seuil de détection, la zone plate ayant une durée au moins égale à une durée prédéfinie, chaque échantillon non singulier étant un échantillon ayant un écart de valeur de courant inférieur à un écart prédéfini avec au moins un échantillon voisin temporellement; calculer la valeur de décalage à partir d'au moins un échantillon non singulier appartenant à la zone plate.

En mettant en oeuvre ce procédé, le compteur électrique prend en compte la composante continue intrinsèque au signal de courant électrique dans le calcul de la puissance apparente consommée par une installation électrique.

Selon un mode de réalisation, lors d'une recherche d'une zone plate, le compteur électrique met en oeuvre une procédure itérative comprenant, pour chaque échantillon du signal de courant, dit échantillon cible, une étape de calcul d'un écart entre une valeur de courant dudit échantillon cible, et une valeur de courant d'un échantillon du signal de courant, dit échantillon voisin, voisin temporellement de l'échantillon cible, une zone plate étant identifiée lorsque, pendant une période égale à ladite durée prédéfinie, le pourcentage d'échantillons non singuliers est supérieur au seuil de détection, chaque échantillon non singulier étant un échantillon cible pour lequel un écart inférieur à l'écart prédéfini a été calculé.

La procédure itérative permet de réduire le nombre d'échantillon sauvegardés en mémoire par le compteur électrique.

Selon un mode de réalisation, lors de la procédure itérative, lorsqu'un écart inférieur à l'écart prédéfini est calculé pour un échantillon cible, une valeur représentative des valeurs de courant de l'échantillon cible et de l'échantillon voisin est ajoutée à une somme de valeurs de courant, la valeur de décalage étant calculée suite à l'identification d'une zone plate en divisant la somme de valeurs de courant par un nombre d'échantillons cibles, compris dans la zone plate, pour lesquels l'écart calculé est inférieur à l'écart prédéfini.

Selon un mode de réalisation, le signal de courant électrique est échantillonné avec une période d'échantillonnage prédéfinie dépendant d'une période du signal de courant électrique, l'échantillon voisin temporellement étant distant de l'échantillon cible d'une durée égale à deux fois la période d'échantillonnage, et la valeur représentative des valeurs de courant de l'échantillon cible et de l'échantillon voisin est égale à la valeur de courant d'un échantillon situé entre l'échantillon cible et l'échantillon voisin à une distance de l'échantillon cible égale à la période d'échantillonnage.

De cette manière, le compteur électrique ne prend pas en compte les premier et dernier échantillons d'une zone plate qui pourraient comporter des valeurs de courant non représentatives des valeurs de courant des autres échantillons compris dans la zone plate.

Selon un mode de réalisation, lors d'une recherche d'une zone plate, le compteur électrique met en oeuvre les étapes suivantes : sauvegarder un ensemble d'échantillons consécutifs du signal de courant électrique, ledit ensemble comprenant un nombre total d'échantillons correspondant à une période de durée au moins égale à ladite durée prédéfinie ; rechercher, parmi les valeurs de courant des échantillons compris dans ledit ensemble, une valeur de courant minimale et une valeur de courant maximale ; identifier une zone plate lorsqu'une différence entre la valeur de courant minimale et la valeur de courant maximale est inférieure audit écart prédéfini, chaque échantillon ayant une valeur de courant comprise entre la valeur de courant maximale et la valeur de courant minimale étant un échantillon non singulier.

Selon un mode de réalisation, lors de la recherche de la valeur de courant minimale et de la valeur de courant maximale, le compteur électrique met en oeuvre une étape de suppression d'au moins un échantillon extrême dudit ensemble de sorte à conserver dans ledit ensemble un pourcentage du nombre total d'échantillons au moins égal au seuil prédéfini, un échantillon extrême étant un échantillon ayant une valeur de courant inférieure aux valeurs de courant des autres échantillons dudit ensemble ou un échantillon ayant une valeur de courant supérieure aux valeurs de courant des autres échantillons dudit ensemble, la valeur de courant minimale et la valeur de courant maximale étant recherchées dans ledit ensemble après mise en oeuvre de l'étape de suppression d'au moins un échantillon extrême.

Selon un mode de réalisation, suite à l'identification d'une zone plate, le compteur électrique détermine la valeur de décalage en calculant une moyenne de valeurs de courant d'échantillons appartenant audit ensemble.

Selon un deuxième aspect de la présente invention, la présente invention concerne un compteur électrique adapté pour déterminer une puissance électrique apparente consommée par une installation électrique supervisée par ledit compteur électrique, un signal de courant électrique étant destiné à être fourni au compteur électrique pour alimenter ladite installation électrique, le compteur électrique comprenant les moyens suivants : un module de mesure pour mesurer une valeur de courant efficace à partir du signal de courant électrique ; un module d'obtention pour obtenir une valeur de décalage de courant ; un module de correction pour corriger une valeur de courant efficace à partir d'une valeur de décalage de courant ; et, un module de calcul d'une valeur de puissance pour calculer une valeur de puissance électrique apparente à partir d'une valeur de courant efficace corrigée. Le module d'obtention comprend les moyens suivants : un module de recherche pour rechercher dans le signal de courant électrique une période, dite zone plate, pour laquelle un pourcentage d'échantillons du signal de courant électrique, dits échantillons non singuliers, est supérieur ou égal à un seuil, dit seuil de détection, la zone plate ayant une durée au moins égale à une durée prédéfinie, chaque échantillon non singulier étant un échantillon ayant un écart de valeur de courant inférieur à un écart prédéfini avec au moins un échantillon voisin temporellement; un module de calcul d'une valeur de décalage pour calculer une valeur de décalage à partir d'au moins un échantillon non singulier appartenant à une zone plate.

Selon un troisième aspect de la présente invention, la présente invention concerne un programme d'ordinateur, comprenant des instructions pour mettre en oeuvre, par un compteur électrique, le procédé selon le premier aspect, lorsque ledit programme est exécuté par un processeur dudit compteur électrique.

Selon un quatrième aspect de la présente invention, la présente invention concerne des moyens de stockage, stockant un programme d'ordinateur comprenant des instructions pour mettre en oeuvre, par un compteur électrique, le procédé selon un premier aspect, lorsque ledit programme est exécuté par un processeur dudit compteur électrique.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un système électrique dans lequel l'invention peut être mise en oeuvre ;
- la Fig. 2 illustre schématiquement un exemple d'architecture matérielle d'un dispositif mettant en oeuvre l'invention ;
- les Figs. 3A et 3B illustrent schématiquement des formes de signal de courant électrique dissymétriques ;
- la Fig. 4 illustre schématiquement un exemple d'algorithme de détermination d'une puissance apparente consommée ;
- la Fig. 5 illustre schématiquement un exemple de méthode d'obtention d'une valeur de décalage de courant permettant de calculer une puissance apparente ;
- la Fig. 6A illustre schématiquement un premier exemple d'algorithme de calcul d'une valeur de décalage de courant ; et,
- la Fig. 6B illustre schématiquement un deuxième exemple d'algorithme de calcul d'une valeur de décalage de courant.

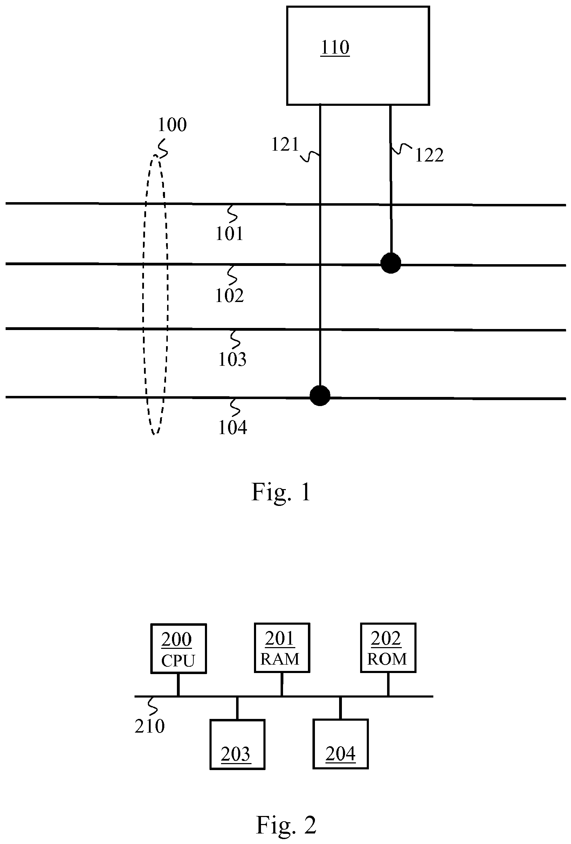

La Fig. 1 illustre schématiquement un système électrique dans lequel l'invention peut être mise en oeuvre.

Le système électrique de la Fig. 1 comporte un réseau d'alimentation électrique 100 constitué d'une pluralité de fils, un fil étant dédié au neutre et au moins un fil étant dédié à au moins une phase. Dans l'exemple de réalisation représenté par la Fig. 1, le réseau d'alimentation électrique 100 est un système à trois phases, et est donc constitué de quatre fils: un fil de neutre 104, un fil d'une première phase 101, un fil d'une deuxième phase 102 et un fil de troisième phase 103. La séparation des phases est donc de 120 degrés entre deux phases, et serait de 180 degrés dans le cas d'un système à deux phases, puisque dans les réseaux électriques polyphasés, les phases sont en général à égale distance angulaire.

Le système électrique de la Fig. 1 pourrait reposer sur un réseau d'alimentation électrique monophasé.

Le système électrique de la Fig. 1 comporte en outre un compteur électrique 110, c'est-à-dire un dispositif servant à mesurer, entre autres, la puissance apparente consommée par une installation électrique que le compteur électrique 110 est en charge de superviser. Le compteur électrique 110 est connecté à un des fils de phase du réseau d'alimentation électrique 100 ainsi qu'au fil de neutre, par des liens respectifs 122 et 121. On est, dans ce cas, en présence d'un compteur électrique monophasé. Le système électrique de la Fig. 1 pourrait reposer sur une mise en oeuvre de compteur électrique polyphasé.

Le signal de tension électrique fourni au compteur électrique 110 par le réseau d'alimentation électrique 100 est une sinusoïde centrée autour de la valeur nulle.

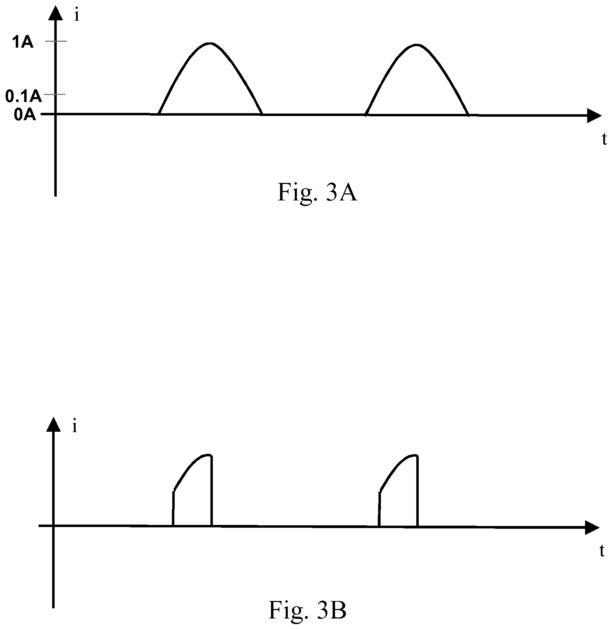

Le signal de courant électrique fourni au compteur électrique 110 par le réseau d'alimentation électrique 100 est quelquefois un signal périodique dissymétrique ayant une période T. Un tel signal est par exemple illustré dans les **Figs. 3A** (signal périodique dissymétrique) et **3B** (signal périodique dissymétrique et sporadique). La Fig. 3A représente un signal en demi-onde, c'est-à-dire que le signal illustré à la Fig. 3A ne reprend que les portions positives d'un signal sinusoïdal centré autour de la valeur nulle et est nul le reste du temps. On retrouve une telle forme de signal dans la norme NF-EN 50470-3:2007 « *Equipement de comptage d'électricité (c.a.) - Partie 3: Proscriptions particulières - Compteurs statiques d'énergie active (classes de précision A, B et C)* ». La Fig. 3B représente un signal en « aileron de requin » (« shark dorsal waveform » en anglais), c'est-à-dire que le signal illustré à la Fig. 3B ne reprend que des portions de phase d'un signal sinusoïdal centré autour de la valeur nulle et est nul le reste du temps. Dans l'exemple de la Fig.3B, ce signal est, au vu de la portion de phase sinusoïdale utilisée, toujours positif. Le signal de courant électrique représenté Fig. 3A n'est qu'un exemple illustratif de signal de courant dissymétrique. Le signal de la Fig.3B n'est qu'un exemple illustratif de signal sporadique et dissymétrique. D'autres formes de signaux peuvent être mises en oeuvre pour créer une telle dissymétrie entre des valeurs positives de signal de courant électrique et des valeurs négatives de signal de courant électrique.

La **Fig. 2** illustre schématiquement un exemple d'architecture matérielle d'au moins une partie du compteur électrique 110. Le compteur électrique 110 comprend alors, reliés par un bus de communication 210 : un processeur ou CPU (« Central Processing Unit » en anglais) 200 ; une mémoire vive RAM (« Random Access Memory» en anglais) 201 ; une mémoire morte ROM (« Read Only Memory» en anglais) 202 ; une unité de stockage ou un lecteur de support de stockage, tel qu'un lecteur de cartes SD (« Secure Digital » en anglais) 203 ; un ensemble 204 d'interfaces de connexion permettant de connecter le compteur électrique 110 au réseau d'alimentation électrique 100.

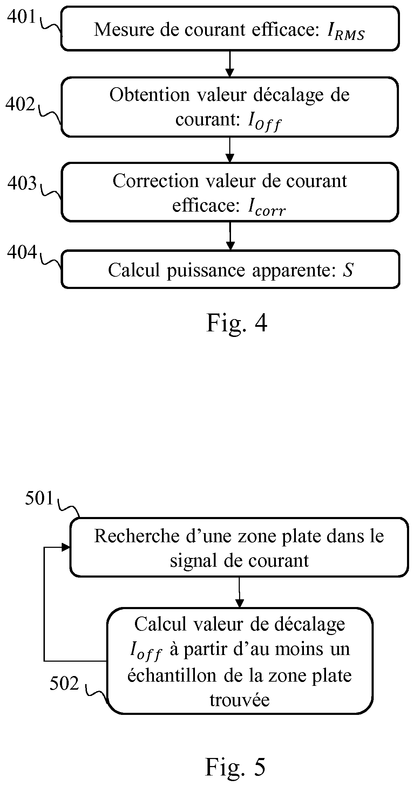

Le processeur 200 est capable d'exécuter des instructions chargées dans la RAM 201 à partir de la ROM 202, d'une mémoire externe (non représentée), d'un support de stockage, tel qu'une carte SD, ou d'un réseau de communication. Lorsque le compteur électrique 110 est mis sous tension, le processeur 200 est capable de lire de la RAM 201 des instructions et de les exécuter. Ces instructions forment un programme d'ordinateur causant la mise en oeuvre, par le processeur 200, de tout ou partie de l'algorithme décrit ci-après en relation avec les Figs. 4, 5, 6A et 6B.

Tout ou partie de l'algorithme décrit ci-après en relation avec les Figs. 4, 5, 6A et 6B peut être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

La **Fig. 4** illustre schématiquement un exemple d'algorithme de détermination d'une puissance apparente consommée par l'installation électrique supervisée par le compteur électrique 110.

Dans une étape 401, le compteur électrique 110 effectue une mesure de courant efficace $I_{RMS}$.

Dans une étape 402, le compteur électrique 110 obtient une valeur de décalage de courant $I_{off}$, appelée simplement valeur de décalage par la suite. Dans un mode de réalisation, cette valeur de décalage $I_{off}$ a été préalablement calculée par le compteur électrique 110 selon une méthode décrite en relation avec la Fig. 5 et sauvegardée en mémoire par le compteur électrique 110. L'obtention par le compteur électrique 110 de la valeur de décalage $I_{off}$ consiste donc alors à aller chercher en mémoire la valeur de décalage $I_{off}$ sauvegardée.

Dans une étape 403, le compteur électrique 110 obtient la valeur de courant efficace corrigée $I_{Corr}$ à partir de la valeur de courant efficace mesurée $I_{RMS}$ et de la valeur de décalage $I_{off}$ selon la méthode suivante :

$$I_{Corr} = \sqrt{I_{RMS}^2 + I_{off}^2}$$

Dans une étape 404, le compteur électrique 110 calcule une puissance apparente $P$ à partir de la valeur de courant efficace corrigée $I_{Corr}$ et d'une valeur de tension efficace $U_{RMS}$. Nous considérons ici que le compteur électrique 110 a mesuré cette valeur de tension efficace $U_{RMS}$ :

$$S = U_{RMS} . I_{Corr}$$

Dans un mode de réalisation, le compteur électrique 110 peut aussi calculer une énergie consommée par l'installation électrique qu'il supervise à partir de valeurs de courant d'échantillons du signal de courant électrique corrigées en utilisant la valeur de décalage $I_{off}$.

La **Fig. 5** illustre schématiquement un exemple de méthode d'obtention d'une valeur de décalage de courant $I_{off}$ permettant de calculer une puissance apparente $S$.

Dans une étape 501, le compteur électrique 110 recherche dans le signal de courant électrique une période, dite zone plate, pour laquelle un pourcentage d'échantillons du signal de courant électrique, dits échantillons non singuliers, est supérieur ou égal à un seuil $P$, dit seuil de détection. La zone plate a une durée au moins égale à une durée prédéfinie $D$. Chaque échantillon non singulier est un échantillon du signal de courant électrique ayant un écart de valeur de courant inférieur à un écart prédéfini $I_{TH}$ avec au moins un échantillon voisin temporellement. L'écart prédéfini $I_{TH}$ est une valeur faible comparativement à une amplitude maximum du signal de courant électrique de courant. En d'autres termes, une zone plate comporte un pourcentage d'échantillons, ayant des valeurs de courant quasi identiques, supérieur ou égale au seuil de détection $P$.

Dans un mode de réalisation, le seuil de détection $P$ est égal à « 100% », de sorte qu'une zone plate est détectée lorsque, pendant une période de durée au moins égale à la durée prédéfinie $D$, chaque échantillon compris dans ladite période est non singulier.

Dans un mode de réalisation, la durée prédéfinie $D$ dépend de la période $T$ du signal. La durée prédéfinie $D$ est, par exemple, un pourcentage $X$ de la période $T$, où le pourcentage $X$ est supérieur ou égal à « 25% ». Selon des contraintes liées à des normes métrologiques, et en particulier pour prendre en compte les signaux du type demi-ondes de courant, il est préférable que X soit inférieur à 50%. X ne doit pas être trop faible, car on risquerait alors de déterminer une correction sur un signal insuffisamment significatif.

Lorsqu'une zone plate est identifiée, le compteur électrique 110 calcule lors d'une étape 502 une valeur de décalage $I_{off}$ à partir d'au moins un échantillon non singulier appartenant à la zone plate. La valeur de décalage $I_{off}$ ainsi calculée est ensuite utilisée pour corriger au moins une valeur de courant efficace $I_{RMS}$ utilisée elle-même pour calculer une valeur de puissance électrique apparente S.

Dans un mode de réalisation, le compteur électrique 110 détermine la valeur de décalage $I_{off}$ en calculant une moyenne des valeurs de courant des échantillons non singuliers de la zone plate.

Dans un mode de réalisation, le compteur électrique 110 détermine la valeur de décalage $I_{off}$ en déterminant une valeur médiane des valeurs de courant des échantillons non singuliers de la zone plate.

Dans un mode de réalisation, le compteur électrique 110 détermine la valeur de décalage $I_{off}$ en sélectionnant aléatoirement une valeur de courant parmi les échantillons non singuliers de la zone plate.

Dans un autre mode de réalisation, le seuil de détection $P$ est fixé à une valeur inférieure à « 100% », pour permettre une détection de zones plates sur des signaux de courant électrique bruités par exemple par un bruit impulsionnel aléatoire. Dans ce cas, le compteur électrique 110 utilise un seuil de détection $P$ compris typiquement entre « 90 » et « 100% ».

Dans un mode de réalisation, le calcul de la valeur de décalage $I_{off}$ est fait en continu par le compteur électrique 110. Par conséquent, suite à l'étape 502, le compteur électrique 110 met de nouveau en oeuvre l'étape 501 pour rechercher une nouvelle zone plate ou détecter qu'une zone plate identifiée se poursuit.

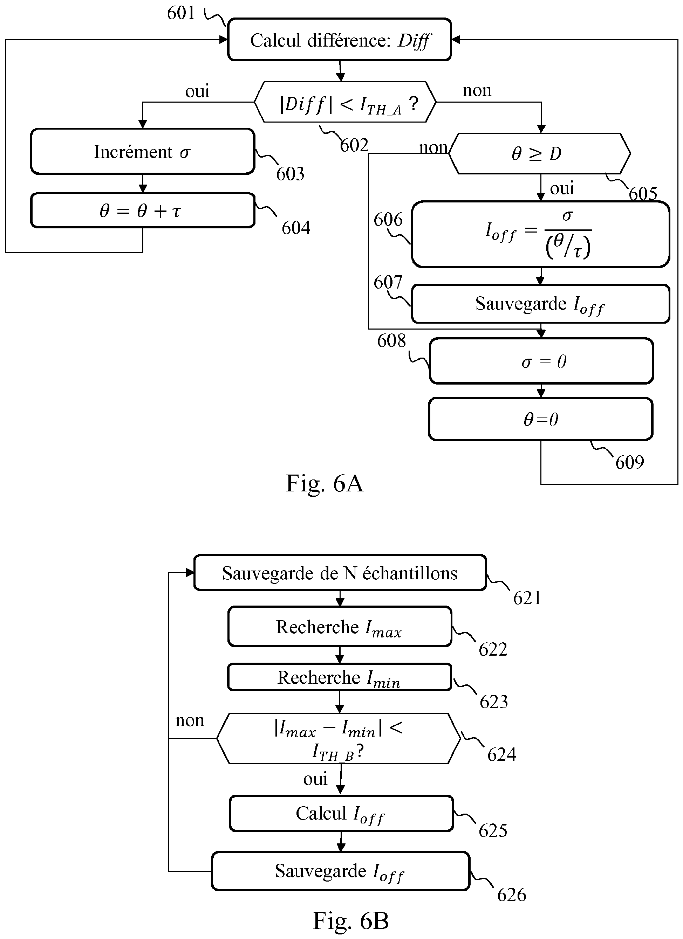

Par la suite, nous décrivons deux algorithmes de calcul d'une valeur de décalage de courant $I_{off}$ en relation avec les Figs. 6A et 6B. Pour chacun de ces algorithmes, nous supposons que le compteur électrique 110 échantillonne le signal de courant électrique suivant une période $\tau$ suffisamment inférieure à la période $T$ du signal de courant électrique. Chaque échantillon du signal de courant électrique est représenté par la suite par une variable $I_n$, où $n$ est un indice de l'échantillon. Deux échantillons $I_n$ et $I_{n+x}$ sont distants temporellement d'une durée $x$. $\tau$, $x$ représentant un entier relatif. Par exemple, un échantillon $I_{n-1}$ précède temporellement un échantillon $I_n$, l'échantillon $I_n$ étant séparé d'une durée égale à la période d'échantillonnage $\tau$ de l'échantillon $I_{n-1}$.

La **Fig. 6A** illustre schématiquement un premier exemple d'algorithme de calcul d'une valeur de décalage de courant $I_{off}$. Cet algorithme détaille un premier exemple de mise en oeuvre de la méthode d'obtention d'une valeur de décalage de courant $I_{off}$ décrite en relation avec la Fig. 5. L'algorithme décrit en relation avec la Fig. 6A met en oeuvre une procédure itérative durant laquelle le compteur électrique 110 calcule successivement pour chaque échantillon du signal de courant, un écart avec un échantillon voisin. Lorsqu'une période d'une durée au moins égale à la durée prédéfinie D comprend un pourcentage d'échantillons non singuliers, associés à un écart inférieur à un écart prédéfini $I_{TH\_A}$, supérieur ou égal au seuil de détection $P$, le compteur électrique 110 identifie une zone plate. Dans l'exemple décrit en relation avec la Fig. 6A, le seuil de détection P est de « 100% ». Le compteur électrique 110 peut alors déterminer une valeur de décalage $I_{off}$ à partir des échantillons non singuliers de la zone plate. Par ailleurs, dans l'exemple décrit en relation avec la Fig. 6A, l'écart prédéfini $I_{TH\_A}$ est typiquement fonction de l'amplitude maximale du signal de courant électrique. A titre d'exemple, pour un courant max de 6A, $I_{TH\_A} = 70mA$ typiquement.

Au lancement de l'algorithme décrit en relation avec la Fig. 6A, le compteur électrique 110 initialise une variable $\sigma$ et une variable $\theta$ à la valeur « 0 ». Comme nous le décrivons par la suite, la variable $\sigma$ est utilisée pour sommer des valeurs de courant. La variable $\theta$ est utilisée pour sommer des écarts temporels entre deux échantillons.

Dans une étape 601, le compteur électrique 110 obtient un échantillon $I_n$ du signal de courant électrique, dit échantillon cible et calcule une différence *Diff* entre la valeur de courant de l'échantillon cible $I_n$ et la valeur de courant d'un échantillon voisin temporellement $I_{n+x}$. Dans un mode de réalisation, la différence *Diff* est calculée entre l'échantillon cible $I_n$ et l'échantillon voisin $I_{n-1}$ avec dans ce cas ($x = -1$).

Dans une étape 602, la valeur absolue de la différence |*Diff*|, que nous appelons écart, est comparée à l'écart prédéfini $I_{TH\_A}$.

Lorsque l'écart |*Diff*| est supérieur ou égal à l'écart prédéfini $I_{TH\_A}$, dans une étape 605, le compteur électrique 110 compare la valeur de la variable $\theta$ à la durée prédéfinie $D$.

Si la valeur de la variable $\theta$ est inférieure à la durée prédéfinie $D$, le compteur électrique 110 met en oeuvre une étape 608.

Si la valeur de la variable $\theta$ est supérieure ou égale à la durée prédéfinie $D$, le compteur électrique 110 considère qu'une zone plate a été identifiée. Le compteur électrique 110 calcule alors une valeur de décalage $I_{off}$. Pour ce faire, lors d'une étape 606, le compteur électrique 110 divise la valeur de la variable $\sigma$ par un nombre d'échantillons cibles, compris dans la zone plate, pour lesquels l'écart calculé est inférieur à l'écart prédéfini $I_{TH\_A}$. Dans l'exemple décrit en relation avec la Fig. 6A, le nombre d'échantillons cibles, compris dans la zone plate, pour lesquels l'écart calculé est inférieur à l'écart prédéfini $I_{TH\_A}$ est égal à $\theta/_\tau$ puisque tous les échantillons de la zone plate sont non singuliers.

Dans une étape 607, la valeur de décalage $I_{off}$ calculée est sauvegardée en mémoire par le compteur électrique 110 pour pouvoir être utilisée lors de calculs de la puissance apparente $S$.

Puis, le compteur électrique 110 réinitialise les variables $\sigma$ et $\theta$ à la valeur « 0 » lors des étapes 608 et 609 et met de nouveau en oeuvre l'étape 601 sur un nouvel échantillon cible $I_n$ en incrémentant l'indice n d'une unité. Dans l'exemple décrit en relation avec la Fig. 6A, le compteur électrique 110 considère qu'il n'est pas en présence d'une zone plate dès qu'un écart |*Diff*| supérieur ou égal à l'écart prédéfini $I_{TH\_A}$ est trouvé.

Lorsque l'écart |*Diff*| est inférieur à l'écart prédéfini $I_{TH\_A}$, le compteur électrique 110 ajoute une valeur de courant représentative de l'échantillon cible $I_n$ et de l'échantillon voisin $I_{n-1}$ à la variable $\sigma$ lors d'une étape 603. Une valeur de courant représentative de l'échantillon cible $I_n$ et de l'échantillon voisin $I_{n-1}$ est par exemple la valeur de courant de l'échantillon cible $I_n$.

Dans une étape 604, le compteur électrique 110 ajoute l'écart temporel entre l'échantillon cible $I_n$ et l'échantillon voisin $I_{n-1}$ à la variable $\theta$. Le signal électrique étant échantillonné à une période $\tau$, l'écart temporel entre l'échantillon cible $I_n$ et l'échantillon voisin $I_{n-1}$ est égal à la période d'échantillonnage $\tau$.

Puis, le compteur électrique 110 met de nouveau en oeuvre l'étape 601 sur un nouvel échantillon cible $I_n$ en incrémentant l'indice $n$ d'une unité

Dans un mode de réalisation, une valeur de courant représentative de l'échantillon cible $I_n$ et de l'échantillon voisin $I_{n-1}$ est par exemple une moyenne des valeurs de courant des échantillons cibles $I_n$ et $I_{n-1}$.

Dans un mode de réalisation, l'échantillon voisin de l'échantillon $I_n$ est l'échantillon $I_{n-2}$. Dans ce mode de réalisation, la valeur de courant représentative de l'échantillon cible $I_n$ et de l'échantillon voisin $I_{n-2}$ est par exemple la valeur de courant de l'échantillon $I_{n-1}$. Ce mode de réalisation permet de ne pas considérer la valeur de courant du premier et du dernier échantillon de la zone plate dans le calcul de la valeur de décalage $I_{off}$. En effet, bien qu'ayant été identifiés comme faisant partie de la zone plate, le premier et le dernier échantillon de la zone plate sont situés dans une zone frontière entre la zone plate, dans laquelle le signal de courant électrique varie faiblement et une zone non plate, dans laquelle le signal de courant électrique subit des variations importantes. Il est en général très difficile de distinguer efficacement une fin (respectivement un début) d'une zone non plate d'un début (respectivement d'une fin) d'une zone plate. Il est donc préférable de ne pas considérer les échantillons compris dans la zone frontière pour ne pas fausser le calcul de la valeur de décalage $I_{off}$.

Dans un mode de réalisation de la procédure itérative, le compteur électrique 110 considère qu'une seule identification, pendant une période égale à la durée prédéfinie D, d'un échantillon cible associé à un écart $|Diff|$ supérieur ou égal à l'écart prédéfini $I_{TH-A}$ n'est pas suffisante pour déterminer qu'il n'est pas en présence d'une zone plate. Dans ce mode de réalisation, le compteur électrique 110 permet que, sur une période égale à la durée prédéfinie $D$, au moins un échantillon cible soit associé à une valeur d'écart $|Diff|$ supérieure ou égale à l'écart prédéfini $I_{TH\_A}$. Toutefois, le compteur n'identifie une zone plate que, si durant ladite période, le pourcentage d'échantillons non singulier est supérieur ou égal au seuil de détection P, le seuil de détection P étant, dans ce cas, inférieur à « 100% », et par exemple compris entre « 90 » et « 100% ».

On peut noter qu'un avantage de la procédure itérative est de minimiser le nombre d'échantillons sauvegardés en mémoire par le compteur électrique 110. En effet, lors de chaque itération, seuls deux à trois échantillons consécutifs sont sauvegardés par le compteur électrique 110.

La **Fig. 6B** illustre schématiquement un deuxième exemple d'algorithme de calcul d'une valeur de décalage de courant. Cet algorithme détaille un deuxième exemple de mise en oeuvre de la méthode d'obtention d'une valeur de décalage de courant $I_{off}$ décrite en relation avec la Fig. 5.

Dans une étape 621, le compteur électrique 110 sauvegarde en mémoire un ensemble d'échantillons comprenant N échantillons consécutifs du signal de courant électrique. Le nombre $N$ est égal à $D/\tau$ et correspond au nombre d'échantillons du signal électrique compris dans une période d'une durée égale à la durée prédéfinie $D$.

Dans une étape 622, le compteur électrique 110 recherche, parmi les $N$ échantillons de l'ensemble d'échantillons sauvegardé en mémoire, un échantillon ayant une valeur de courant maximum $I_{max}$.

Dans une étape 623, le compteur électrique 110 recherche, parmi les $N$ échantillons de l'ensemble d'échantillons sauvegardé en mémoire, un échantillon ayant une valeur de courant minimum $I_{min}$.

Dans une étape 624, le compteur électrique 110 calcule une différence entre la valeur de courant maximale $I_{max}$ et la valeur de courant minimale $I_{min}$ et compare la valeur absolue de cette différence à un écart prédéfini $I_{TH\_B}$. Dans l'exemple décrit en relation avec la Fig. 6B, l'écart prédéfini $I_{TH\_B}$ est égal à l'écart prédéfini $I_{TH\_A}$.

Lorsque la valeur absolue de la différence entre la valeur de courant maximale $I_{max}$ et la valeur de courant minimale $I_{min}$ est supérieure ou égale à $I_{TH\_B}$, le compteur électrique 110 détermine que les N échantillons de l'ensemble d'échantillons sauvegardé ne forment pas une zone plate. Dans ce cas, le compteur électrique 110 met de nouveau en oeuvre l'étape 621 et sauvegarde un nouvel ensemble d'échantillons comprenant N échantillons consécutifs du signal de courant électrique.

Afin de limiter des accès mémoire lors de l'étape 621, lors de chaque création d'un nouvel ensemble d'échantillons, le compteur électrique 110 utilise une zone mémoire de taille fixe, de type mémoire circulaire, pour sauvegarder l'ensemble d'échantillons. Chaque échantillon sauvegardé dans la mémoire circulaire possède un indice dépendant de l'ordre d'arrivée de l'échantillon dans la mémoire circulaire. Dans l'exemple de l'ensemble d'échantillons comprenant $N$ échantillons, l'échantillon $I_n$ d'indice $n$ est l'échantillon le plus ancien de la mémoire circulaire, alors que l'échantillon $I_{n+N-1}$ d'indice $n+N-1$ est l'échantillon le plus récent. Lors d'une création d'un nouvel ensemble d'échantillons, le compteur électrique 110 supprime de la mémoire circulaire l'échantillon le plus ancien et le remplace par un nouvel échantillon. Par exemple, l'échantillon $I_n$ est supprimé et remplacé par un échantillon $I_{n+N}$ suivant temporellement l'échantillon $I_{n+N-1}$.

Lorsque la valeur absolue de la différence entre la valeur de courant maximale $I_{max}$ et la valeur de courant minimale $I_{min}$ est inférieure à $I_{TH\_B}$, le compteur électrique 110 considère que les N échantillons de l'ensemble d'échantillons forment une zone de plat.

Le compteur électrique 110 peut alors, lors d'une étape 625, calculer une valeur de décalage $I_{off}$ à partir des échantillons compris dans l'ensemble d'échantillons. Par exemple, le compteur électrique 110 calcule la moyenne des valeurs de courant des N échantillons compris dans l'ensemble d'échantillons.

Lors d'une étape 626, la valeur de décalage $I_{off}$ calculée est sauvegardée en mémoire par le compteur électrique 110 pour pouvoir être utilisée lors de calculs de la puissance apparente $S$.

L'étape 626 est suivie de l'étape 621.

Jusque-là, nous avons considéré dans l'exemple décrit en relation avec la Fig. 6B, que chaque échantillon de l'ensemble d'échantillons devait avoir une valeur de courant comprise entre des valeurs $I_{min}$ et $I_{max}$ telles que $|I_{max} - I_{min}| < I_{TH\_B}$ pour que la période correspondante du signal électrique soit considérée comme une zone de plat. En d'autres termes, chaque échantillon d'une zone plate est non singulier et l'écart entre deux échantillons de la zone plate, voisins temporellement ou pas, est inférieur à l'écart prédéfini $I_{TH\_B}$.

Afin de pouvoir traiter des signaux de courant électrique bruités, dans un mode de réalisation, le compteur électrique 110 autorise qu'une zone de plat contienne un nombre faible d'échantillons singuliers dont l'écart de valeur de courant avec au moins un échantillon de l'ensemble d'échantillons est supérieur à l'écart prédéfini $I_{TH\_B}$. Le nombre d'échantillons singuliers autorisés est tel que le pourcentage d'échantillons non singuliers restant dans la période de durée égale à la durée prédéfinie D est supérieur au seuil de détection $P$. Pour ce faire, dans un mode de réalisation, le compteur électrique 110 supprime au moins un échantillon extrême de l'ensemble d'échantillons. Un échantillon extrême est un échantillon ayant une valeur de courant inférieure aux valeurs de courant des autres échantillons dudit ensemble ou un échantillon ayant une valeur de courant supérieure aux valeurs de courant des autres échantillons dudit ensemble. Par exemple, le compteur électrique 110 supprime de l'ensemble d'échantillons, un échantillon ayant une valeur de courant inférieure aux valeurs de courant des autres échantillons de l'ensemble d'échantillons et/ou un échantillon ayant une valeur de courant supérieure aux valeurs de courant des autres échantillons de l'ensemble d'échantillons. Dans ce mode de réalisation, la recherche de la valeur de courant minimale et de la valeur de courant maximale se fait dans l'ensemble d'échantillons obtenu après suppression d'au moins un échantillon extrême.

Dans un mode de réalisation, $I_{TH\_B}$ est différent de $I_{TH\_A}$ et est égal par exemple à « 2% » de l'amplitude maximale du signal de courant électrique, ou plutôt 120mA dans le cas d'une amplitude maximale de 6A.

Un emplacement mémoire non volatil est préférentiellement utilisé pour stocker la valeur de décalage $I_{off}$, de manière à permettre au compteur électrique 110 d'avoir au moins une valeur de décalage $I_{off}$ à utiliser pour le calcul de la puissance apparente, lorsque, suite à une coupure d'alimentation, le système redémarre avec un signal de courant électrique dissymétrique.

La valeur de décalage $I_{off}$ pourrait ne pas être déterminée de manière continue par le compteur électrique 110 mais uniquement périodiquement. En effet, bien que la valeur de décalage puisse évoluer dans le temps, notamment en fonction de variations de température ambiante autour du compteur électrique 110, la période de variation est généralement lente. Dans un mode de réalisation, le compteur électrique 110 lance, par exemple, une phase d'évaluation de la valeur de décalage de courant $I_{off}$ toutes les heures.

**Revendications**

1. Procédé de détermination par un compteur électrique (110) d'une puissance électrique apparente consommée par une installation électrique supervisée par ledit compteur électrique, un signal de courant électrique étant fourni au compteur électrique pour alimenter ladite installation électrique, le procédé comprend les étapes suivantes mises en oeuvre par le compteur électrique :

   • mesurer (401) une valeur de courant efficace à partir du signal de courant électrique ;
   • obtenir (402) une valeur de décalage de courant ;
   • corriger (403) la valeur de courant efficace en utilisant la valeur de décalage de courant obtenue ; et,
   • calculer (404) une valeur de puissance électrique apparente à partir de la valeur de courant efficace corrigée ;

   le procédé étant **caractérisé en ce que** le compteur électrique met en oeuvre les étapes suivantes pour déterminer la valeur de décalage de courant :

   • rechercher (501) dans le signal de courant électrique une période, dite zone plate, pour laquelle un pourcentage d'échantillons du signal de courant électrique, dits échantillons non singuliers, est supérieur ou égal à un seuil, dit seuil de détection, la zone plate ayant une durée au moins égale à une durée prédéfinie, chaque échantillon non singulier étant un échantillon ayant un écart de valeur de courant inférieur à un écart prédéfini avec au moins un échantillon voisin temporellement;
   • calculer (502) la valeur de décalage à partir d'au moins un échantillon non singulier appartenant à la zone plate.

2. Procédé selon la revendication 1, **caractérisé en ce que**, lors d'une recherche d'une zone plate, le compteur électrique met en oeuvre une procédure itérative comprenant, pour chaque échantillon du signal de courant électrique, dit échantillon cible, une étape de calcul (601) d'un écart entre une valeur de courant dudit échantillon cible, et une valeur de courant d'un échantillon du signal de courant, dit échantillon voisin, voisin temporellement de l'échantillon cible, une zone plate étant identifiée (605) lorsque, pendant une période égale à ladite durée prédéfinie, le pourcentage d'échantillons non singuliers est supérieur au seuil de détection, chaque échantillon non singulier étant un échantillon cible pour lequel un écart inférieur à l'écart prédéfini a été calculé.

3. Procédé selon la revendication 2, **caractérisé en ce que**, lors de la procédure itérative, lorsqu'un écart inférieur à l'écart prédéfini est calculé (601, 602) pour un échantillon cible, une valeur représentative des valeurs de courant de l'échantillon cible et de l'échantillon voisin est ajoutée (603) à une somme de valeurs de courant, la valeur de décalage étant calculée suite à l'identification (605) d'une zone plate en divisant (606) la somme de valeurs de courant par un nombre d'échantillons cibles, compris dans la zone plate, pour lesquels l'écart calculé est inférieur à l'écart prédéfini.

4. Procédé selon la revendication 2 ou 3, **caractérisé en ce que** le signal de courant électrique est échantillonné avec une période d'échantillonnage prédéfinie dépendant d'une période du signal de courant électrique, l'échantillon voisin temporellement étant distant de l'échantillon cible d'une durée égale à deux fois la période d'échantillonnage, et la valeur représentative des valeurs de courant de l'échantillon cible et de l'échantillon voisin est égale à la valeur de courant d'un échantillon situé entre l'échantillon cible et l'échantillon voisin à une distance de l'échantillon cible égale à la période d'échantillonnage.

5. Procédé selon la revendication 1, **caractérisé en ce que**, lors d'une recherche d'une zone plate, le compteur électrique met en oeuvre les étapes suivantes :

   • sauvegarder (621) un ensemble d'échantillons consécutifs du signal de courant électrique, ledit ensemble comprenant un nombre total d'échantillons correspondant à une période de durée au moins égale à ladite durée prédéfinie ;
   • rechercher (622, 623), parmi les valeurs de courant des échantillons compris dans ledit ensemble, une valeur de courant minimale et une valeur de courant maximale ;
   • identifier (624) une zone plate lorsqu'une différence entre la valeur de courant minimale et la valeur de courant maximale est inférieure audit écart prédéfini, chaque échantillon ayant une valeur de courant comprise entre la valeur de courant maximale et la valeur de courant minimale étant un échantillon non singulier.

6. Procédé selon la revendication 5, **caractérisé en ce que**, lors de la recherche de la valeur de courant minimale et de la valeur de courant maximale, le compteur électrique met en oeuvre une étape de suppression d'au moins un échantillon extrême dudit ensemble de sorte à conserver dans ledit ensemble un pourcentage du nombre total d'échantillons au moins égal au seuil prédéfini, un échantillon extrême étant un échantillon ayant une valeur de courant inférieure aux valeurs de courant des autres échantillons dudit ensemble ou un échantillon ayant une valeur de courant supérieure aux valeurs de courant des échantillons dudit ensemble, la valeur de courant minimale et la valeur de courant maximale étant recherchées dans ledit ensemble après mise en oeuvre de l'étape de suppression d'au moins un échantillon extrême.

7. Procédé selon la revendication 5 ou 6, **caractérisé en ce que**, suite à l'identification (624) d'une zone plate, le compteur électrique détermine la valeur de décalage en calculant une moyenne de valeurs de courant d'échantillons appartenant audit ensemble.

8. Compteur électrique (110) adapté pour déterminer une puissance électrique apparente consommée par une installation électrique supervisée par ledit compteur électrique, un signal de courant électrique étant destiné à être fourni au compteur électrique pour alimenter ladite installation électrique, le compteur électrique comprenant les moyens suivants :

   • un module de mesure (401) pour mesurer une valeur de courant efficace à partir du signal de courant électrique ;
   • un module d'obtention (402) pour obtenir une valeur de décalage de courant ;
   • un module de correction (403) pour corriger une valeur de courant efficace à partir d'une valeur de décalage de courant ; et,
   • un module de calcul d'une valeur de puissance (404) pour calculer une valeur de puissance électrique apparente à partir d'une valeur de courant efficace corrigée ;

   le compteur électrique étant **caractérisé en ce que** le module d'obtention comprend les moyens suivants,

   • un module de recherche (501) pour rechercher dans le signal de courant électrique une période, dite zone plate, pour laquelle un pourcentage d'échantillons du signal de courant électrique, dits échantillons non singuliers, est supérieur ou égal à un seuil, dit seuil de détection, la zone plate ayant une durée au moins égale à une durée prédéfinie, chaque échantillon non singulier étant un échantillon ayant un écart de valeur de courant inférieur à un écart prédéfini avec au moins un échantillon voisin temporellement;
   • un module de calcul d'une valeur de décalage (502) pour calculer une valeur de décalage à partir d'au moins un échantillon non singulier appartenant à une zone plate.

9. Programme d'ordinateur, **caractérisé en ce qu'**il comprend des instructions pour mettre en oeuvre, par un compteur électrique, le procédé selon l'une quelconque des revendications 1 à 7, lorsque ledit programme est exécuté par un processeur dudit compteur électrique.

10. Moyens de stockage, **caractérisés en ce qu'**ils stockent un programme d'ordinateur comprenant des instructions pour mettre en oeuvre, par un compteur électrique, le procédé selon l'une quelconque des revendications 1 à 7, lorsque ledit programme est exécuté par un processeur dudit compteur électrique.

**Patentansprüche**

1. Verfahren zur Bestimmung, durch einen elektrischen Zähler (110), einer elektrischen Scheinleistung, die von einer vom elektrischen Zähler überwachten elektrischen Anlage verbraucht wird, wobei ein elektrisches Stromsignal an den elektrischen Zähler geliefert wird, um die elektrische Anlage zu versorgen,
wobei das Verfahren die folgenden Schritte enthält, die vom elektrischen Zähler durchgeführt werden:

   • Messen (401) eines Effektivstromwerts ausgehend vom elektrischen Stromsignal;
   • Erhalten (402) eines Strom-Offsetwerts;
   • Korrigieren (403) des Effektivstromwerts unter Verwendung des erhaltenen Strom-Offsetwerts; und
   • Berechnen (404) eines elektrischen Scheinleistungswerts ausgehend vom korrigierten Effektivstromwert;

   wobei das Verfahren **dadurch gekennzeichnet ist, dass** der elektrische Zähler die folgenden Schritte durchführt, um den Strom-Offsetwert zu bestimmen:

   • Suchen (501), im elektrischen Stromsignal, einer Periode, Flachzone genannt, in der ein Prozentsatz von Tastproben des elektrischen Stromsignals, nichtsinguläre Tastproben genannt, höher als eine oder gleich einer Schwelle ist, Erfassungsschwelle genannt, wobei die Flachzone eine Dauer mindestens gleich einer vordefinierten Dauer hat, wobei jede nichtsinguläre Tastprobe eine Tastprobe ist, die eine niedrigere Stromwertabweichung als eine vordefinierte Abweichung zu mindestens einer zeitlich benachbarten Tastprobe hat;
   • Berechnen (502) des Offsetwerts ausgehend von mindestens einer zur Flachzone gehörenden nichtsingulären Tastprobe.

2. Verfahren nach Anspruch 1, **dadurch gekennzeichnet, dass** bei einer Suche nach einer Flachzone der elektrische Zähler eine iterative Prozedur durchführt, die für jede Tastprobe des elektrischen Stromsignals, Zieltastprobe genannt, einen Schritt der Berechnung (601) einer Abweichung zwischen einem Stromwert der Zieltastprobe und einem Stromwert einer Tastprobe des Stromsignals, benachbarte Tastprobe genannt, die zeitlich der Zieltastprobe benachbart ist, enthält, wobei eine Flachzone erkannt wird (605), wenn während einer Periode gleich der vordefinierten Dauer der Prozentsatz von nichtsingulären Tastproben höher ist als die Erfassungsschwelle, wobei jede nichtsinguläre Tastprobe eine Zieltastprobe ist, bei der eine niedrigere Abweichung als die vordefinierte Abweichung berechnet wurde.

3. Verfahren nach Anspruch 2, **dadurch gekennzeichnet, dass** während der iterativen Prozedur, wenn eine niedrigere Abweichung als die vordefinierte Abweichung (601, 602) für eine Zieltastprobe berechnet wird, ein für die Stromwerte der Zieltastprobe und der benachbarten Tastprobe repräsentativer Wert einer Summe von Stromwerten hinzugefügt wird (603), wobei der Offsetwert nach der Erkennung (605) einer Flachzone berechnet wird, indem die Summe von Stromwerten durch eine Anzahl von Zieltastproben dividiert wird (606), die in der Flachzone enthalten ist, für die die berechnete Abweichung niedriger als die vordefinierte Abweichung ist.

4. Verfahren nach Anspruch 2 oder 3, **dadurch gekennzeichnet, dass** das elektrische Stromsignal mit einer vordefinierten Abtastperiode abgetastet wird, die von einer Periode des elektrischen Stromsignals abhängt, wobei die zeitlich benachbarte Tastprobe von der Zieltastprobe um eine Dauer gleich der doppelten Abtastperiode entfernt ist, und der für die Stromwerte der Zieltastprobe und der benachbarten Tastprobe repräsentative Wert gleich dem Stromwert einer Tastprobe ist, die sich zwischen der Zieltastprobe und der benachbarten Tastprobe in einer Entfernung von der Zieltastprobe gleich der Abtastperiode befindet.

5. Verfahren nach Anspruch 1, **dadurch gekennzeichnet, dass** bei der Suche nach einer Flachzone der elektrische Zähler die folgenden Schritte durchführt:

   • Sichern (621) einer Einheit von aufeinanderfolgenden Tastproben des elektrischen Stromsignals, wobei die Einheit eine Gesamtanzahl von Tastproben enthält, die einer Periode einer Dauer mindestens gleich der vordefinierten Dauer entspricht;
   • Suchen (622, 623), unter den Stromwerten der in der Einheit enthaltenen Tastproben, eines minimalen Stromwerts und eines maximalen Stromwerts;
   • Erkennen (624) einer Flachzone, wenn eine Differenz zwischen dem minimalen Stromwert und dem maximalen Stromwert kleiner ist als die vordefinierte Abweichung, wobei jede Tastprobe mit einem Stromwert zwischen dem maximalen Stromwert und dem minimalen Stromwert eine nichtsinguläre Tastprobe ist.

6. Verfahren nach Anspruch 5, **dadurch gekenn-**

zeichnet, dass bei der Suche nach dem minimalen Stromwert und dem maximalen Stromwert der elektrische Zähler einen Schritt der Unterdrückung mindestens einer End-Tastprobe der Einheit durchführt, um in der Einheit einen Prozentsatz der Gesamtanzahl von Tastproben mindestens gleich der vordefinierten Schwelle beizubehalten, wobei eine End-Tastprobe eine Tastprobe mit einem niedrigeren Stromwert als die Stromwerte der anderen Tastproben der Einheit oder eine Tastprobe mit einem höheren Stromwert als die Stromwerte der Tastproben der Einheit ist, wobei der minimale Stromwert und der maximale Stromwert in der Einheit nach der Durchführung des Schritts der Unterdrückung mindestens einer End-Tastprobe gesucht werden.

7. Verfahren nach Anspruch 5 oder 6, **dadurch gekennzeichnet, dass** nach der Erkennung (624) einer Flachzone der elektrische Zähler den Offsetwert bestimmt, indem er einen Mittelwert von Stromwerten von Tastproben berechnet, die zu der Einheit gehören.

8. Elektrischer Zähler (110), der geeignet ist, um eine elektrische Scheinleistung zu bestimmen, die von einer vom elektrischen Zähler überwachten elektrischen Anlage verbraucht wird, wobei ein elektrisches Stromsignal dazu bestimmt ist, an den elektrischen Zähler geliefert zu werden, um die elektrische Anlage zu versorgen, wobei der elektrische Zähler die folgenden Einrichtungen enthält:

    • ein Messmodul (401), um ausgehend vom elektrischen Stromsignal einen Effektivstromwert zu messen;
    • ein Erhaltungsmodul (402), um einen Strom-Offsetwert zu erhalten;
    • ein Korrekturmodul (403), um ausgehend von einem Strom-Offsetwert einen Effektivstromwert zu korrigieren; und
    • ein Berechnungsmodul eines Leistungswerts (404), um ausgehend von einem korrigierten Effektivstromwert einen elektrischen Scheinleistungswert zu berechnen;

wobei der elektrische Zähler **dadurch gekennzeichnet ist, dass** das Erhaltungsmodul die folgenden Einrichtungen enthält:

    • ein Suchmodul (501), um im elektrischen Stromsignal eine Periode, Flachzone genannt, zu suchen, für die ein Prozentsatz von Tastproben des elektrischen Stromsignals, nichtsinguläre Tastproben genannt, größer als eine oder gleich einer Schwelle ist, Erfassungsschwelle genannt, wobei die Flachzone eine Dauer mindestens gleich einer vordefinierten Dauer hat, wobei jede nichtsinguläre Tastprobe eine Tastprobe ist, die eine niedrigere Stromwertabweichung als eine vordefinierte Abweichung zu mindestens einer zeitlich benachbarten Tastprobe hat;
    • ein Berechnungsmodul eines Offsetwerts (502), um einen Offsetwert ausgehend von mindestens einer nichtsingulären Tastprobe zu berechnen, die zu einer Flachzone gehört.

9. Computerprogramm, **dadurch gekennzeichnet, dass** es Anweisungen enthält, um das Verfahren nach einem der Ansprüche 1 bis 7 durch einen elektrischen Zähler durchzuführen, wenn das Programm von einem Prozessor des elektrischen Zählers ausgeführt wird.

10. Speichereinrichtungen, **dadurch gekennzeichnet, dass** sie ein Computerprogramm speichern, das Anweisungen enthält, um das Verfahren nach einem der Ansprüche 1 bis 7 durch einen elektrischen Zähler durchzuführen, wenn das Programm von einem Prozessor des elektrischen Zählers ausgeführt wird.

**Claims**

1. Method for determining, by means of an electricity meter (110), an apparent amount of electrical power consumed by an electrical installation monitored by said electricity meter, an electric current signal being delivered to the electricity meter in order to supply power to said electrical installation,
the method comprising the following steps implemented by the electricity meter:

    • measuring (401) an RMS current value on the basis of the electric current signal;
    • obtaining (402) a current shift value;
    • correcting (403) the RMS current value using the obtained current shift value; and
    • calculating (404) an apparent electrical power value on the basis of the corrected RMS current value;

the method being **characterized in that** the electricity meter implements the following steps in order to determine the current shift value:

    • searching (501) in the electric current signal for a period, referred to as a flat area, for which a percentage of samples of the electric current signal, referred to as non-singular samples, is higher than or equal to a threshold, referred to as the detection threshold, the flat area having a duration that is at least equal to a predefined duration, each non-singular sample being a sample having a difference in current value that is smaller than a predefined difference with at least one temporally neighbouring sample;
• calculating (502) the shift value on the basis of at least one non-singular sample belonging to the flat area.

2. Method according to Claim 1, **characterized in that**, when searching for a flat area, the electricity meter implements an iterative procedure comprising, for each sample of the electric current signal, referred to as a target sample, a step of calculating (601) a difference between a current value of said target sample, and a current value of a sample of the current signal, referred to as a neighbouring sample, which sample temporally neighbours the target sample, a flat area being identified (605) when, over a period that is equal to said predefined duration, the percentage of non-singular samples is higher than the detection threshold, each non-singular sample being a target sample for which a difference that is smaller than the predefined difference has been calculated.

3. Method according to Claim 2, **characterized in that**, during the iterative procedure, when a difference that is smaller than the predefined difference is calculated (601, 602) for a target sample, a value that is representative of the current values of the target sample and of the neighbouring sample is added (603) to a sum of current values, the shift value being calculated following the identification (605) of a flat area by dividing (606) the sum of current values by a number of target samples, comprised in the flat area, for which samples the calculated difference is smaller than the predefined difference.

4. Method according to Claim 2 or 3, **characterized in that** the electric current signal is sampled with a predefined sampling period that is dependent on a period of the electric current signal, the temporally neighbouring sample being located away from the target sample by a duration that is equal to twice the sampling period, and the value that is representative of the current values of the target sample and of the neighbouring sample is equal to the current value of a sample located between the target sample and the neighbouring sample at a distance from the target sample that is equal to the sampling period.

5. Method according to Claim 1, **characterized in that**, when searching for a flat area, the electricity meter implements the following steps:

• saving (621) a set of consecutive samples of the electric current signal, said set comprising a total number of samples corresponding to a period the duration of which is at least equal to said predefined duration;
• searching (622, 623), among the current values of the samples comprised in said set, for a minimum current value and a maximum current value;
• identifying (624) a flat area when a difference between the minimum current value and the maximum current value is smaller than said predefined difference, each sample having a current value comprised between the maximum current value and the minimum current value being a non-singular sample.

6. Method according to Claim 5, **characterized in that**, when searching for the minimum current value and for the maximum current value, the electricity meter implements a step of removing at least one extreme sample from said set so as to retain in said set a percentage of the total number of samples that is at least equal to the predefined threshold, an extreme sample being a sample having a current value that is smaller than the current values of the other samples of said set or a sample having a current value that is higher than the current values of the samples of said set, the minimum current value and the maximum current value being sought in said set after implementing the step of removing at least one extreme sample.

7. Method according to Claim 5 or 6, **characterized in that**, following the identification (624) of a flat area, the electricity meter determines the shift value by calculating a mean of current values of samples belonging to said set.

8. Electricity meter (110) suitable for determining an apparent amount of electrical power consumed by an electrical installation monitored by said electricity meter, an electric current signal being intended to be delivered to the electricity meter in order to supply power to said electrical installation, the electricity meter comprising the following means:

• a measurement module (401) for measuring an RMS current value on the basis of the electric current signal;
• an obtention module (402) for obtaining a current shift value;
• a correction module (403) for correcting an RMS current value on the basis of a current shift value; and
• a power value calculation module (404) for calculating an apparent electrical power value on the basis of a corrected RMS current value;

the electricity meter being **characterized in that** the obtention module comprises the following means:

• a search module (501) for searching in the electric current signal for a period, referred to as a flat area, for which a percentage of samples of the electric current signal, referred to as non-singular samples, is higher than or equal to a threshold, referred to as the detection threshold, the flat area having a duration that is at least equal to a predefined duration, each non-singular sample being a sample having a difference in current value that is smaller than a predefined difference with at least one temporally neighbouring sample;
• a shift value calculation module (502) for calculating a shift value on the basis of at least one non-singular sample belonging to a flat area.

9. Computer program, **characterized in that** it comprises instructions for implementing, by means of an electricity meter, the method according to any one of Claims 1 to 7, when said program is run by a processor of said electricity meter.

10. Storage means, **characterized in that** they store a computer program comprising instructions for implementing, by means of an electricity meter, the method according to any one of Claims 1 to 7, when said program is run by a processor of said electricity meter.

Fig. 1

Fig. 2

Fig. 3A

Fig. 3B

401 — Mesure de courant efficace: $I_{RMS}$

402 — Obtention valeur décalage de courant: $I_{Off}$

403 — Correction valeur de courant efficace: $I_{corr}$

404 — Calcul puissance apparente: $S$

Fig. 4

501 — Recherche d'une zone plate dans le signal de courant

502 — Calcul valeur de décalage $I_{off}$ à partir d'au moins un échantillon de la zone plate trouvée

Fig. 5

601

Calcul différence: *Diff*

oui $|Diff| < I_{TH\_A}$ ? non

602

Incrément $\sigma$

603

$\theta = \theta + \tau$

604

non $\theta \geq D$

605

oui

606 $I_{off} = \dfrac{\sigma}{(\theta/\tau)}$

607 Sauvegarde $I_{off}$

608 $\sigma = 0$

$\theta = 0$

609

## Fig. 6A

Sauvegarde de N échantillons

621

Recherche $I_{max}$

622

Recherche $I_{min}$

623

non $|I_{max} - I_{min}| < I_{TH\_B}$ ?

624

oui

Calcul $I_{off}$

625

Sauvegarde $I_{off}$

626

## Fig. 6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060129339 A1

- WO 0129572 A1